Europäisches Patentamt

European Patent Office

Office européen des brevets

(11) Veröffentlichungsnummer: **0 339 519**
**A2**

## (12) EUROPÄISCHE PATENTANMELDUNG

(21) Anmeldenummer: 89107282.9

(51) Int. Cl.⁴: **G03F 7/08**

(22) Anmeldetag: 22.04.89

(30) Priorität: 27.04.88 DE 3814179

(43) Veröffentlichungstag der Anmeldung:
02.11.89 Patentblatt 89/44

(84) Benannte Vertragsstaaten:
**BE DE FR GB IT NL**

(71) Anmelder: **BASF Aktiengesellschaft**
**Carl-Bosch-Strasse 38**
**D-6700 Ludwigshafen(DE)**

(72) Erfinder: **Nick, Bernhard, Dr.**
**Sinsheimer Strasse 20**
**D-6700 Ludwigshafen(DE)**
Erfinder: **Leyrer, Reinhold J., Dr.**
**Menzelstrasse 4**
**D-6700 Ludwigshafen(DE)**
Erfinder: **Lauke, Harald, Dr.**
**Sophienstrasse 10**
**D-6800 Mannheim 1(DE)**

(54) **Lichtempfindliches Gemisch zur Herstellung von Aufzeichnungsmaterialien.**

(57) Die Erfindung betrifft ein lichtempfindliches, negativ arbeitendes Aufzeichnungsmaterial, das Diazoniumsalze als lichtempfindliche Verbindungen, Metallsalze sowie gegebenenfalls polymere Bindemittel und andere übliche Hilfs- und Zusatzstoffe enthält sowie ein Verfahren zur Herstellung von Flachdruckplatten.

EP 0 339 519 A2

## Lichtempfindliches Gemisch zur Herstellung von Aufzeichnungsmaterialien

Die Erfindung betrifft ein negativ arbeitendes lichtempfindliches Aufzeichnungsmaterial, das ein Diazoniumsalz, ein Bindemittel sowie Metallsalz enthält sowie ein Verfahren zur Herstellung von Flachdruckplatten.

Negativ arbeitende, lichtempfindliche Gemische, die ein Diazoniumsalz und ein polymeres Bindemittel enthalten, haben ein breites Anwendungsgebiet speziell als lichtempfindliche Decklacke für Offsetdruckplatten gefunden. Dabei wird die Änderung der Löslichkeit durch Belichtung ausgenutzt. Eine Offsetdruckplatte wird im allgemeinen hergestellt, indem man ein Gemisch aus lichtempfindlichem Material, z.B. Diazoverbindung mit einem Bindemittel und anderen Hilfsstoffen, z.B. Stabilisatoren, Sensibilisatoren und Farbstoffen, auf einem hydrophilen Metall oder Papier, bevorzugt in üblicher Weise vorbehandeltes Aluminium, aufträgt. Durch Belichtung werden die bestrahlten Stellen auf der Druckplatte unlöslich, so daß die nicht belichteten Stellen mit einem Entwickler entfernt werden können. Dadurch werden hydrophile und lipophile Stellen auf der Druckplatte gebildet, so daß mit Wasser und Farbe gedruckt werden kann.

Zur Belichtung können üblicherweise Quecksilberhochdrucklampen, Halogenlampen oder Laser, die im sichtbaren Bereich oder im nahen UV-Licht emittieren, eingesetzt werden.

In der deutschen Patentschrift DE 27 28 858 wird ausgeführt, daß die Lichtempfindlichkeit von Offsetdruckplatten dadurch erhöht werden kann, daß der lichtempfindlichen Schicht Farbstoffe oder wasserlösliche Metallsalze zugefügt werden, die mit dem Laser eingestrahltes Licht absorbieren und damit eine sensibilisierende Wirkung ausüben. Als besonders geeignet werden folgende Metallsalze aufgeführt: Kobaltchlorid, Uranylnitrat, Cadmiumchlorid, Ammoniumeisen-III-sulfat, Cadmiumnitrat, Cer-III-chlorid, Cadmiumsulfat, Ammoniumeisen-II-sulfat, Ammoniumcer-IV-nitrat, Cadmiumacetat, Kobalt-III-acetylacetonat, Kobalt-II-acetat, Natriumhexanitrokobaltat, Nickelchlorid und Manganchlorid.

In der französischen Patentschrift Nr. 2 250 136 wird eine Offsetdruckplatte beschrieben, die neben einem Diazoniumsalz noch Kobaltionen enthält. Die dort beschriebenen Kobaltionen stammen aus wasserlöslichen Kobaltsalzen, speziell aus Kobaltchlorid, Kobaltsulfat und Kobaltnitrat. Da diese Salze alle im Bereich von 290 bis 600 nm ein Absorptionsmaximum aufweisen, ist anzunehmen, daß sie eingestrahltes Licht absorbieren, die Energie an die Diazo-Verbindung abgeben und auf diese Weise die Steigerung der Lichtempfindlichkeit der vorsensibilisierten Schicht bewirken.

Aufgabe der vorliegenden Erfindung war es, ein lichtempfindliches Gemisch auf Basis von Diazoniumsalzen für die Herstellung von Aufzeichnungsmaterialien, insbesondere Flachdruckplatten, aufzuzeigen, das eine erhöhte Lichtempfindlichkeit aufweist, deshalb geringere Belichtungszeiten erfordert als bekannte Gemische und das eine erhöhte Reproduktionsgenauigkeit aufweist.

Überraschend wurde gefunden, daß Metallsalze, die im eingestrahlten Bereich kein Absorptionsmaximum aufweisen, die Lichtempfindlichkeit der Gemische erhöhen. Nicht geklärt ist der Mechanismus, der diesen Effekt begründet, eine Sensibilisierung durch Absorption eingestrahlter Energie durch die Metallsalze und Übertragung dieser Energie auf die Diazosalze scheidet wegen der geringen Absorption dieser Salze im eingestrahlten Bereich aus. Außerdem wurde festgestellt, daß die beschriebenen lichtempfindlichen Gemische eine erhöhte Reproduktionsgenauigkeit aufweisen, wie an der Wiedergabe von feinen Linien festgestellt werden kann.

Gegenstand der vorliegenden Erfindung ist ein lichtempfindliches, negativ arbeitendes Aufzeichnungsmaterial, das mindestens ein Diazoniumsalz als lichtempfindliche Verbindung, mindestens ein Metallsalz sowie gegebenenfalls polymere Bindemittel und andere übliche Hilfs- und Zusatzstoffe enthält, das dadurch gekennzeichnet ist, daß es als Metallsalz das eines Metallkations eines Nebengruppenelements oder eines Elements der dritten oder vierten Hauptgruppe des Periodensystems der Elemente, ausgenommen Kobalt, enthält und das Absorptionsspektrum des Metallsalzes, gemessen in methanolischer Lösung, kein Absorptionsmaximum im Bereich von 290 bis 600 nm aufweist.

Das Absorptionsspektrum wird üblicherweise in einem inerten Lösungsmittel, wie Methanol, aufgenommen.

Vorzugsweise enthält das Aufzeichnungsmaterial als Metallsalze Kupfer-, Zink- und/oder Bleisalze. Die Salze von Carbonsäuren werden ganz besonders bevorzugt. Die Metallsalze sind im allgemeinen in Mengen von 0.05 bis 10, vorzugsweise 0,5 bis 5 Gew.%, bezogen auf die Gesamtmenge des Aufzeichnungsmaterials enthalten.

Gegenstand der vorliegenden Erfindung ist außerdem ein Verfahren zur Herstellung von Flachdruckplatten, wobei man das erfindungsgemäße lichtempfindliche Aufzeichnungsmaterial in gelöster Form auf einen in üblicher Weise vorbehandelten Aluminiumträger aufbringt und das Lösungsmittel ent fernt. Bevorzugte Schichtdicken sind hierbei 0.1 bis 50, vorzugsweise 1 bis 5 μm.

Als Diazoniumsalze geeignet sind die üblicherweise verwendeten negativ arbeitenden, lichthärtbaren Diazoverbindungen. Insbesondere geeignet sind Polykondensationsprodukte von Diazoniumsalzen, z.B. von Diphenylamin-4-Diazoniumsalzen, mit Aldehyden.

Als polymere Bindemittel, die auch Bestandteil des lichtempfindlichen Gemisches sein können, kommen z.B. Polyurethane, Polyacrylate oder Novolacke in Frage.

Das lichtempfindliche Gemisch kann ferner weitere bekannte Bestandteile enthalten, wie Farbstoffe, Pigmente, stabilisierende Säuren und Belichtungsindikatoren.

Farbstoffe und Pigmente, die sich als gegebenenfalls mitzuverwendende Hilfs- oder Zusatzstoffe für das Aufzeichnungsmaterial eignen, sind z.B. Acetosol-Grün BLS, Erythrosin, Viktoriareinblau, Methylenblau, Neozappon-Feuerrot oder Pigmente, wie Kupferphthalocyanin.

Als stabilisierende Säuren sind z.B. Phosphor-, Zitronen-, Wein- und Toluolsulfonsäure geeignet.

Geeignete Lösemittel für die Bestandteile des erfindungsgemäßen Gemisches sind z.B. Ethylenglykolether, Alkohole oder niedere Ketone. Im allgemeinen werden die Lösemittel nach dem Auftragen des Gemischs auf einen Aluminiumträger durch Verdampfen entfernt. Der Aluminiumträger kann vorher durch Drahtbürsten, Naßschleifen oder elektrochemisch aufgerauht und anschliessend elektrochemisch mit einer Oxidschicht versehen sein.

Durch Verwendung des erfindungsgemäßen Gemisches ergeben sich gegenüber bekannten negativ arbeitenden lichtempfindlichen Gemischen entscheidende Vorteile: Die Lichtempfindlichkeit einer mit diesem Gemisch beschichteten Druckplatte ist deutlich erhöht, was kürzere Belichtungszeiten und eine schnellere Verarbeitung in der Druckerei bedeutet; zusätzlich ist die Reproduktionsgenauigkeit erhöht, so daß sich eine bessere Druckqualität ergibt.

Die Erfindung wird anhand der folgenden Beispiele und Vergleichsbeispiele erläutert. Teile sind Gewichtsteile, Prozente oder Mengenverhältnisse sind in Gewichtseinheiten angegeben.

Vergleichsbeispiel 1:

Ein elektrochemisch durch Wechselstrombehandlung in wäßriger HCl- und $HNO_3$-Lösung aufgerauhtes und anodisch in Schwefelsäure oxidiertes Aluminiumblech wird mit einem lichtempfindlichen Gemisch so beschichtet, daß das Schichtgewicht 2 g/m$^2$ beträgt.

Das lichtempfindliche Gemisch besitzt folgende Zusammensetzung:

| | |
|---|---|
| 86 % | Bindemittel (Copolymerisat aus Hydroxyethylmethacrylat, Acrylnitril, Ethylmethacrylat, Methacrylsäure 45:10:35:10) |
| 2 % | Weinsäure |
| 3 % | Kobaltnitrat (Absorptionsmaximum bei 515 nm) |
| 8,9 % | Diazoniumsalz (Kondensationsprodukt aus p-Diazodiphenylaminhydrogensulfat und Formaldehyd) |
| 0,1 % | Erythrosin |

Der so beschichtete Träger wird unter einer Quecksilberdampflampe (45 Sekunden Belichtungszeit, 3 kW Leistungsaufnahme, Emissionsspektrum von 290 bis 500 nm, Hauptemission zwischen 350 und 450 nm) durch eine Testvorlage belichtet und mit einem wäßrig-alkalischen Entwickler entwickelt. Auf einem Halbtonkeil (UGRA-Testkeil) wird die Lichtempfindlichkeit an der voll gedeckten Stufe und die Reproduktionsgenauigkeit an der Wiedergabe feiner Linien abgelesen.

Voll gedeckt ist Stufe 2.

Wiedergegeben werden feine Linien bis zu einer Breite von 20 μm.

Vergleichsbeispiel 2:

Ein vorbehandeltes Aluminiumblech wird wie in Vergleichsbeispiel 1 angegeben beschichtet, belichtet, entwickelt und ausgewertet.

Zur Beschichtung wird folgendes Gemisch verwendet:

3

| 85 % | Bindemittel (Copolymerisat aus N-(4-Hydroxyphenylmethacrylamid, Acrylnitril, Methylacrylat, Methacrylsäure 10:25:60:5) |
|---|---|
| 12 % | Diazoniumsalz (Kondensationsprodukt aus p-Diazodiphenylamin-hexafluorophosphat und Formaldehyd) |
| 2 % | Weinsäure |
| 1 % | Viktoriareinblau |

Voll gedeckt ist Stufe 1 bis 2.

Wiedergegeben werden feine Linien bis zu einer Breite von 25 μm.

Vergleichsbeispiel 3:

Ein vorbehandeltes Aluminiumblech wird wie in Vergleichsbeispiel 1 angegeben, jedoch ohne Kobaltnitrat, beschichtet, belichtet, entwickelt und ausgewertet.

Zusätzlich werden zum Gemisch 3% Natriumacetat (kein Absorptionsmaximum zwischen 290 und 600 nm) gegeben.

Voll gedeckt ist keine Stufe des Stufenkeils.

Wiedergegeben werden feine Linien bis zu einer Breite von 70 μm.

Vergleichsbeispiel 4:

Ein vorbehandeltes Aluminiumblech wird wie in Vergleichsbeispiel 2 angegeben beschichtet, belichtet, entwickelt und ausgewertet.

Zusätzlich werden zum Gemisch 1,5% Natriumacetat (kein Absorptionsmaximum zwischen 290 und 600 nm) gegeben.

Voll gedeckt ist keine Stufe des Stufenkeils.

Wiedergegeben werden feine Linien bis zu einer Breite von 70 μm.

Beispiel 1:

Ein vorbehandeltes Aluminiumblech wird wie in Vergleichsbeispiel 1 angegeben, jedoch ohne Kobaltnitrat, beschichtet, belichtet, entwickelt und ausgewertet; das lichtempfindliche Gemisch enthält jedoch zusätzlich 3% Kupferacetat (kein Absorptionsmaximum zwischen 290 und 600 nm).

Voll gedeckt ist Stufe 4 bis 5.

Wiedergegeben werden feine Linien bis zu einer Breite von 10 μm.

Beispiel 2:

Ein vorbehandeltes Aluminiumblech wird wie in Vergleichsbeispiel 2 angegeben beschichtet, belichtet, entwickelt und ausgewertet; das lichtempfindliche Gemisch enthält jedoch zusätzlich 1,5% Kupferacetat (kein Absorptionsmaximum zwischen 290 und 600 nm).

Voll gedeckt ist Stufe 3.

Wiedergegeben werden feine Linien bis zu einer Breite von 12 μm.

Beispiel 3:

Ein vorbehandeltes Aluminiumblech wird wie in Vergleichsbeispiel 2 angegeben beschichtet, belichtet, entwickelt und ausgewertet; das lichtempfindliche Gemisch enthält jedoch zusätzlich 1,5% Kupfernitrat (kein Absorptionsmaximum zwischen 290 und 600 nm).

Voll gedeckt ist Stufe 2 bis 3.

Wiedergegeben werden feine Linien bis zu einer Breite von 20 μm.

Beispiel 4:

Ein vorbehandeltes Aluminiumblech wird wie in Vergleichsbeispiel 1 angegeben beschichtet, belichtet, entwickelt und ausgewertet.

Zur Beschichtung wird folgendes Gemisch verwendet:

| 90 % | Bindemittel (Copolymerisat aus N-Phenylmethacrylamid, Acrylnitril, Methacrylat, Methacrylsäure 10:25:60:5) |
|------|------|
| 8 % | Diazoniumsalz (Kondensationsprodukt aus p-Diazodiphenylamin-hexafluorophosphat und Formaldehyd) |
| 1,5% | Weinsäure |
| 0,5% | Viktoriareinblau |
| 1,5% | Bleiacetat |

(Bleiacetat weist kein Absorptionsmaximum zwischen 290 und 600 nm auf).

Voll gedeckt ist Stufe 3.

Wiedergegeben werden feine Linien bis zu einer Breite von 12 $\mu$m.

Beispiel 5:

Ein vorbehandeltes Aluminiumblech wird wie in Beispiel 4 angegeben beschichtet, belichtet, entwickelt und ausgewertet; das lichtempflindliche Gemisch enthält jedoch zusätzlich anstatt 1,5% 2,5% Bleiacetat.

Voll gedeckt ist Stufe 3 bis 4.

Wiedergegeben werden feine Linien bis zu einer Breite von 10 $\mu$m.

Beispiel 6:

Ein vorbehandeltes Aluminiumblech wird wie in Beispiel 4 angegeben beschichtet, belichtet, entwickelt und ausgewertet; das lichtempfindliche Gemisch enthält jedoch anstatt Bleiacetat zusätzlich 1% Zinkacetat (kein Absorptionsmaximum zwischen 290 und 600 nm).

Voll gedeckt ist Stufe 3.

Wiedergegeben werden feine Linien bis zu einer Breite von 15 $\mu$m.

Beispiel 7:

Ein vorbehandeltes Aluminiumblech wird wie in Beispiel 4 angegeben beschichtet, belichtet, entwickelt und ausgewertet; das lichtempfindliche Gemisch enthält jedoch anstatt Bleiacetat zusätzlich 3% Zinkacetat.

Voll gedeckt ist Stufe 3 bis 4.

Wiedergegeben werden feine Linien bis zu einer Breite von 15 $\mu$m.

**Ansprüche**

1. Lichtempfindliches, negativ arbeitendes Aufzeichnungsmaterial, das mindestens ein Diazoniumsalz als lichtempfindliche Verbindung, mindestens ein Metallsalz sowie gegebenenfalls polymere Bindemittel und andere übliche Hilfs- und Zusatzstoffe enthält, dadurch gekennzeichnet, daß es als Metallsalz das eines Metallkations eines Nebengruppenelements oder eines Elements der dritten oder vierten Hauptgruppe des Periodensystems der Elemente, ausgenommen Kobalt, enthält und das Absorptionsspektrum des Metallsalzes, gemessen in methanolischer Lösung, kein Absorptionsmaximum im Bereich von 290 bis 600 nm aufweist.

2. Aufzeichnungsmaterial, dadurch gekennzeichnet, daß es als Metallsalz ein Kupfer-, Zink- und/oder Bleisalz enthält.

3. Aufzeichnungsmaterial nach Anspruch 1 oder 2, dadurch gekennzeichnet, daß es als Metallsalze Salze von Carbonsäuren enthält.

4. Aufzeichnungsmaterial nach Anspruch 1, 2 oder 3, dadurch gekennzeichnet, daß es 0.05 bis 10 Gewichtsprozent, bezogen auf die Gesamtmenge des Aufzeichnungsmaterials, Kupfer-, Zink- oder Bleisalz enthält.

5. Verfahren zur Herstellung von Flachdruckplatten, dadurch gekennzeichnet, daß man lichtempfindliches Aufzeichnungsmaterial nach einem der Ansprüche 1 bis 4 in gelöster Form auf einen in üblicher Weise vorbehandelten Aluminiumträger aufbringt und das Lösungsmittel entfernt.